# EUROPEAN PATENT APPLICATION

(11) **EP 4 847 930 A1**
(43) Date of publication of application: **02.12.2026**
(21) Application number: 26174216.7
(22) Date of filing: 23.04.2026
(51) Int. Cl.: G01R 31/3185, G01R 31/28, G01R 31/00

(54) **EMBEDDED TEST STRUCTURES FOR TSV- INTEGRATED 3D BACK-TO-BACK DIE STACKING**

(30) Priority: 31.05.2025 US 202519224743
(71) Applicant: The Boeing Company, Arlington, VA 22202 (US)
(72) Inventor: SONG, Young, Arlington, 22202 (US); DO, Cindy, Arlington, 22202 (US); TANEJA, Nimita, Arlington, 22202 (US); HEISEN, Peter T., Arlington, 22202 (US); DAVIS, Annette, Arlington, 22202 (US)
(74) Representative: Finlayson, Scott Henry

(57) **Abstract**

Embedded test structures for through-silicon via integrated 3D back-to-back die and wafer stacking are described. A method of testing through-silicon via integrated die stacks includes providing a plurality of stacked dies that are joined circuit-face to circuit-face, circuit-face to reverse-face, or reverse-face to reverse-face; wherein the stacked dies comprise an embedded test structure that provides through-silicon via connectivity within the plurality of stacked dies; coupling test equipment to a number of probe points located on an exterior of the plurality of stacked dies, wherein the number of probe points provide through-silicon via connectivity within the plurality of stacked dies; and testing at least one of the plurality of stacked dies for function performance within tolerance with regard to at least one specification.

## Description

### BACKGROUND INFORMATION

### 1. Field:

The present disclosure relates generally to semiconductors, and more specifically to embedded test structures for testing through-silicon vias integrated into 2.5D and 3D stacks of semiconductor dies.

### 2. Background:

Designing and fabricating test-only wafers are costly undertakings. Other disadvantages include limited detection capabilities, and the destructive nature of some methods. Specially designed and fabricated test wafers do not even address the issue of proof-testing products to be shipped.

Therefore, it would be desirable to have a method and apparatus that takes into account at least some of the issues discussed above, as well as other possible issues.

### SUMMARY

Designing and fabricating test-only wafers are avoided by embedded structures that enable comprehensive connectivity testing of Thru-Silicon Via (TSV) and interconnection layers without affecting die size, performance, or requiring additional backend processes. This approach also addresses several current limitations, such as high-costs, limited detection capabilities, and the destructive nature of some methods, since it provides a non-destructive, continuous monitoring solution suitable for both process development and production. The embedded test structures allow flexibility in the design, including the placement of dummy TSVs and probe points, without compromising electrical performance.

Embodiments of this disclosure can include connectivity test structures that are embedded in stacked dies with TSV integration. These connectivity test structures can be used with a Process Control Module (PCM). TSV features embedded in a die permit testing of the chip's functional elements and features without specially designed and fabricated test wafers. Embedded structure may be coupled with ground, power, or test IOs, and a "daisy chain" test connection can be formed on the microbump Pad-RDL layer and during the Cu pillar bumping process in die stacking post-processes.

A first aspect of the present disclosure provides a method of testing a through-silicon via integrated die stack comprising providing a plurality of stacked dies that are joined circuit-face to circuit-face, circuit-face to reverse-face, and/or reverse-face to reverse-face, wherein each of the stacked dies comprises an embedded test structure that provides through-silicon via connectivity within the plurality of stacked dies; coupling test equipment to a number of probe points located on an exterior of the plurality of stacked dies, wherein the number of probe points provide through-silicon via connectivity within the plurality of stacked dies; and testing at least one of the plurality of stacked dies for function performance within tolerance with regard to at least one specification.

The plurality of stacked dies may comprise at least 3 stacked dies.

The number of probe points may be located on one exterior side of one of the plurality of stacked dies with regard to a plane defined by a silicon level within one of the plurality of stacked dies.

The number of probe points may be located on one exterior face of an exterior die of the plurality of stacked dies.

Function performance of a number of chips located within the plurality of stacked dies may be unimpeded by the embedded test structure.

A number of chips located within the plurality of stacked dies may be unpowered during testing.

The number of probe points may comprise a primary probe point, a common ground or final probe point, and/or at least one optional probe point.

Each of the plurality of stacked dies may be electrically connected to at least one other of the plurality of stacked dies by micro-bumps or copper columns.

Function performance of a number of chips located within the plurality of stacked dies may be unimpeded by testing.

A second aspect of the present disclosure provides an apparatus comprising a through-silicon via integrated die stack, comprising: a plurality of stacked dies that are joined active-circuit-layer-face to active-circuit-layer-face, active-circuit-layer-face to reverse-face, and/or reverse-face to reverse-face, wherein each of the stacked dies comprises an embedded test structure that provides through-silicon via connectivity within the plurality of stacked dies; and a number of probe points located on an exterior of the plurality of stacked dies, wherein the number of probe points provide through-silicon via connectivity within the plurality of stacked dies.

The plurality of stacked dies may comprise at least 3 stacked dies.

The number of probe points may be located on one exterior side of one of the plurality of stacked dies with regard to a plane defined by a silicon level within one of the plurality of stacked dies.

The number of probe points may be located on one exterior face of an exterior die of the plurality of stacked dies.

Function performance of a number of chips located within the plurality of stacked dies may be unimpeded by the embedded test structure.

The number of probe points may comprise a primary probe point, a common ground or final probe point, and at least one optional probe point.

Each of the plurality of stacked dies may be electrically connected to at least one other of the plurality of stacked dies by micro-bumps or copper columns.

A substrate may be coupled to an active-circuit-layer-face of one of the plurality of stacked dies.

The substrate may comprise an embedded test structure that provides through-silicon via connectivity to the plurality of stacked dies.

The substrate may comprise a plurality of alternative probe points opposite the plurality of stacked dies.

A third aspect of the present disclosure provides an apparatus comprising a through-silicon via integrated wafer stack, comprising: a plurality of stacked wafers that are joined active-circuit-layer-face to active-circuit-layer-face, active-circuit-layer-face to reverse-face, and/or reverse-face to reverse-face, wherein each of the stacked wafers comprises a plurality of embedded test structures that provides through-silicon via connectivity within the plurality of stacked wafer; and a number of probe points located on an exterior face of the plurality of stacked wafers, wherein the number of probe points provide through-silicon via connectivity within the plurality of stacked wafers.

As the reader will understand, features pertaining to the second aspect may apply equally to the third aspect, save for the fact that a wafer stack is used rather than a die stack.

A fourth aspect of the present disclosure provides an apparatus comprising a method of testing a through-silicon-via integrated wafer stack comprising a plurality of stacked wafers that are joined circuit-face to circuit-face, circuit-face to reverse-face, and/or reverse-face to reverse-face, wherein each of the stacked wafers comprises an embedded test structure that provides through-silicon via connectivity within the plurality of stacked wafers; coupling test equipment to a number of probe points located on an exterior of the plurality of stacked wafers, wherein the number of probe points provide through-silicon via connectivity within the plurality of stacked wafers; and testing at least one of the plurality of stacked wafers for function performance within tolerance with regard to at least one specification.

The features and functions can be achieved independently in various embodiments of the present disclosure or may be combined in yet other embodiments in which further details can be seen with reference to the following description and drawings.

### BRIEF DESCRIPTION OF THE DRAWINGS

The novel features believed characteristic of the illustrative embodiments are set forth in the appended claims. The illustrative embodiments, however, as well as a preferred mode of use, further objectives and features thereof, will best be understood by reference to the following detailed description of an illustrative embodiment of the present disclosure when read in conjunction with the accompanying drawings, wherein:
**Figure 1** is an illustration of an aircraft in accordance with an illustrative embodiment;
**Figure 2** is an illustration of a block diagram of a generic through-silicon via integrated back-to-back die stack with embedded test structure in accordance with an illustrative embodiment;
**Figures 3A-3B** are illustrations of test structure in accordance with an illustrative embodiment;
**Figures 4A-4C** are illustrations of test structure in accordance with an illustrative embodiment;
**Figures 5A-5E** are illustrations of test structure in accordance with an illustrative embodiment;
**Figures 6A-6B** are illustrations of test structure in accordance with an illustrative embodiment;
**Figures 7A-7D** are illustrations of test structure in accordance with an illustrative embodiment;
**Figures 8A-8D** are illustrations of test structure in accordance with an illustrative embodiment;
**Figures 9A-9D** are illustrations of test structure in accordance with an illustrative embodiment;
**Figure 10** is an illustration of test structure in accordance with an illustrative embodiment;
**Figure 11** is an illustration of test structure in accordance with an illustrative embodiment;
**Figure 12** is an illustration of test structure in accordance with an illustrative embodiment;
**Figure 13** is an illustration of test structure in accordance with an illustrative embodiment;
**Figures 14A-14B** are illustrations of test structure in accordance with an illustrative embodiment;
**Figures 15A-15B** are illustrations of test structure in accordance with an illustrative embodiment;
**Figure 16** is a flowchart of a method of hot isostatic pressing of metal hydride feedstock in accordance with an illustrative embodiment;
**Figure 17** is an illustration of an aircraft manufacturing and service method in a form of a block diagram in accordance with an illustrative embodiment; and
**Figure 18** is an illustration of an aircraft in a form of a block diagram in which an illustrative embodiment may be implemented.

### DETAILED DESCRIPTION

This disclosure introduces a novel approach to embedding test structures for TSV (Through-Silicon Via) connectivity within stacked dies, aimed at enhancing Process Control Modules (PCM) for TSV integration processes. Unlike traditional daisy chain test structures, which require additional Non-Recurring Engineering (NRE) costs and are limited to sample wafers, the proposed embedded test structures eliminate the need for such costly methods. This innovation allows for simplified and more efficient testing processes that improve process lead time, reduce costs, and minimize potential damage, while maintaining high throughput and yield in production environments. The embedded structures enable comprehensive connectivity testing of TSVs and interconnection layers without affecting die size, performance, or requiring additional backend processes.

This approach also addresses several limitations of existing inspection techniques-such as high costs, limited detection capabilities, and the destructive nature of some methods-by providing a nondestructive, continuous monitoring solution suitable for both process development and production. Furthermore, the embedded test structures allow flexibility in their design, including the placement of dummy TSVs and probe points, without compromising electrical performance. This advancement represents a significant step toward more effective and economical process control in advanced package Assembly and Test.

The embedded test structures are designed to provide Process Control Modules (PCM) for stacked dies with TSV integration. There is no need to build daisy chain test structures for the die stacking processes: Daisy chain test structures require additional NRE for process development. They can only be used on sample wafers, not on production wafers. Adopting embedded test structures allows for ongoing research and development to: Improve process lead time due to a simplified testing process using the PCM feature, Reduce costs, Minimize potential damage while maintaining high throughput and yield in production environments.

Due to the sophisticated TSVs in 3D ICs, rigorous inspection methods are Employed X-ray Imaging: - Non-destructive and capable of inspecting the TSV fill and detecting voids or defects within the TSV. Scanning Acoustic Microscopy (SAM): to detect delamination, voids, and cracks within the TSVs and the surrounding dielectric material. Scanning Electron Microscopy (SEM): high-resolution imaging of the TSV structure, particularly useful after the reveal process. Focused Ion Beam (FIB): for both inspection and failure analysis by allowing cross-sectional analysis of TSVs. Electrical Testing: To ensures the electrical functionality of the TSVs by measuring resistance, capacitance, and other electrical parameters. Daisy chain test structures for the die stacking/interlocking processes, only be used on sample wafers not for production wafers.

A minimum of 3 dummy TSVs is required. A daisy chain should be formed on the microbump Pad-RDL layer and during the Cu pillar bumping process in die stacking post-processes. Probe points: Top metal layer, or a designated bump if feasible (requires additional effort to handle DRC violations).

Connectivity test structures are already embedded in stacked dies with TSV integration, which can be used for the Process Control Module (PCM). No need to create additional sample dies for process development, The bottom die size can be the same as the top die. These structures are suitable for both process development and process control monitoring in the production phase.

Most failure modes occur between TSV stacking and micro-bumping in back-to-back die connections. Existing solutions can only monitor process control through destructive methods or visual/x-ray inspection during process development. There is currently no way to check embedded connectivity for process control before the socket-level package test.

Embodiments can have more 3 TSVs on a die and they can be placed where the space is available. Increasing the number of TSVs provides more points for PCM connection. The invented structure can be connected to any nets such as Power, Ground, or Test IOs, if there is no impact on performance. C4/C4 bumps can be used instead of probing pads.

Embodiments can provide cost savings. No additional NRE required to build mechanical sample dies for process development. Embodiments can provide cost avoidance. Embedded PCM helps suppliers prevent yield loss incidents. Embodiment can support miniaturized features and 3D heterogeneous integration by stacking more dies with TSV back-to-back integration, enabling low cost PCM solutions.

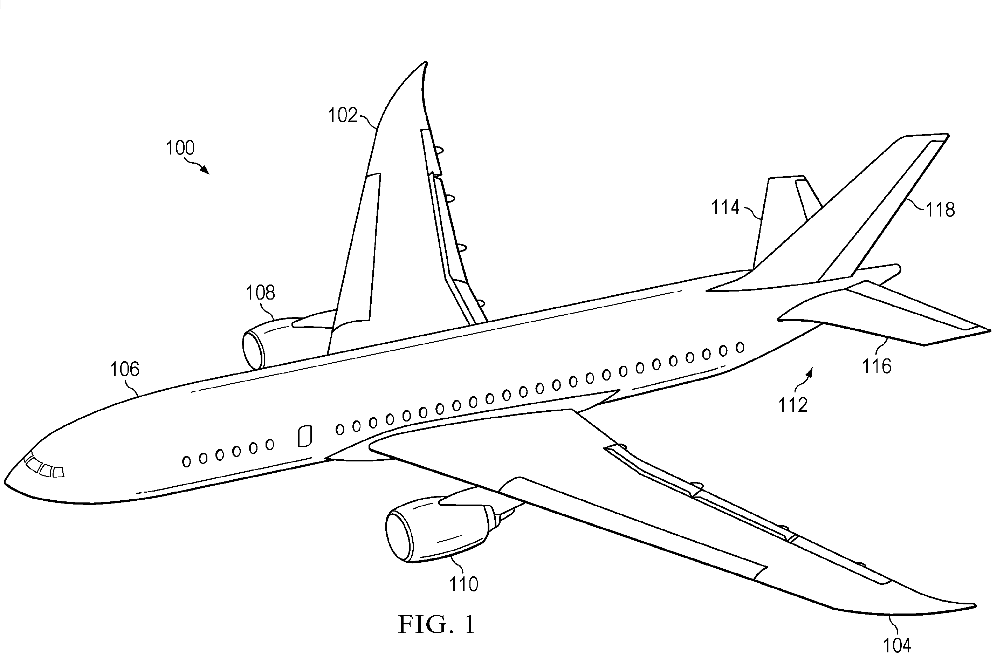

Turning now to **Figure 1****,** an illustration of an aircraft is depicted in accordance with an illustrative embodiment. Aircraft **100** has wing **102** and wing **104** attached to body **106.** Aircraft **100** includes engine **108** attached to wing **102** and engine **110** attached to wing **104.**

Body **106** has tail section **112.** Horizontal stabilizer **114,** horizontal stabilizer **116,** and vertical stabilizer **118** are attached to tail section **112** of body **106.** Aircraft **100** includes electronics such as avionics.

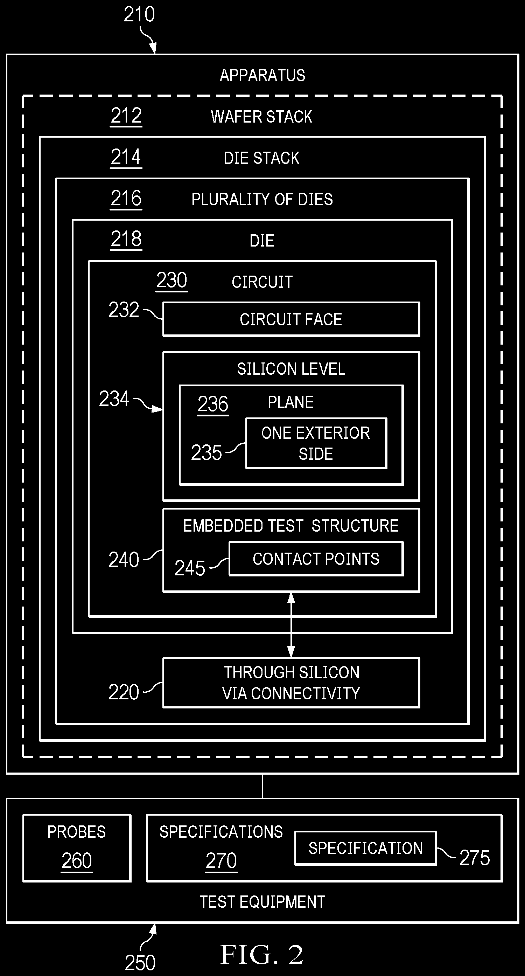

Turning now to **Figure 2****,** an illustration of a generic through-silicon via integrated back-to-back die stack with embedded test structure coupled to test equipment is depicted in accordance with an illustrative embodiment. Apparatus **210** is coupled to test equipment **250.** Apparatus **210** includes wafer stack **212.** Wafer stack **212** is optional and not present in all embodiments. Apparatus **210** includes die stack **214.** Die stack **214** includes a plurality of dies **216.** Plurality of dies **216** includes die **218.** Plurality of dies **216** also includes through-silicon via connectivity **220.** Through-silicon via connectivity connects all of the dies in the plurality of dies **216.**

Still referring to **Figure 2****,** die **218** includes circuit **230.** Circuit **230** defines circuit face **232.** Circuit **230** includes silicon level **234.** Silicon level **234** defines plane **236.** Plane **236** defines one exterior side **238.** Circuit **230** includes embedded test structure **240.** Embedded test structure **240** includes contact points **245.** Test equipment **250** includes probes **260.** Test equipment **250** includes specifications **270.** Specifications **270** includes specification **275.**

This disclosure introduces a novel approach to embedding test structures for TSV (Through-Silicon Via) connectivity within stacked dies, aimed at enhancing Process Control Modules (PCM) for TSV integration processes. Unlike traditional daisy chain test structures, which require additional Non-Recurring Engineering (NRE) costs and are limited to sample wafers, the proposed embedded test structures eliminate the need for such costly methods. This innovation allows for simplified and more efficient testing processes that improve process lead time, reduce costs, and minimize potential damage, while maintaining high throughput and yield in production environments. The embedded structures enable comprehensive connectivity testing of TSVs and interconnection layers without affecting die size, performance, or requiring additional backend processes. This approach also addresses several limitations of existing inspection techniques-such as high costs, limited detection capabilities, and the destructive nature of some methods-by providing a non-destructive, continuous monitoring solution suitable for both process development and production. Furthermore, the embedded test structures allow flexibility in their design, including the placement of dummy TSVs and probe points, without compromising electrical performance. This advancement represents a significant step toward more effective and economical process control in advanced package Assembly and Test.

The embedded test structures are designed to provide Process Control Modules (PCM) for stacked dies with TSV integration. There is no need to build daisy chain test structures for the die stacking processes. Daisy chain test structures require additional NRE for process development. They can only be used on sample wafers, not on production wafers. Adopting embedded test structures allows for ongoing research and development to: improve process lead time due to a simplified testing process using the PCM feature, reduce costs, and minimize potential damage while maintaining high throughput and yield in production environments.

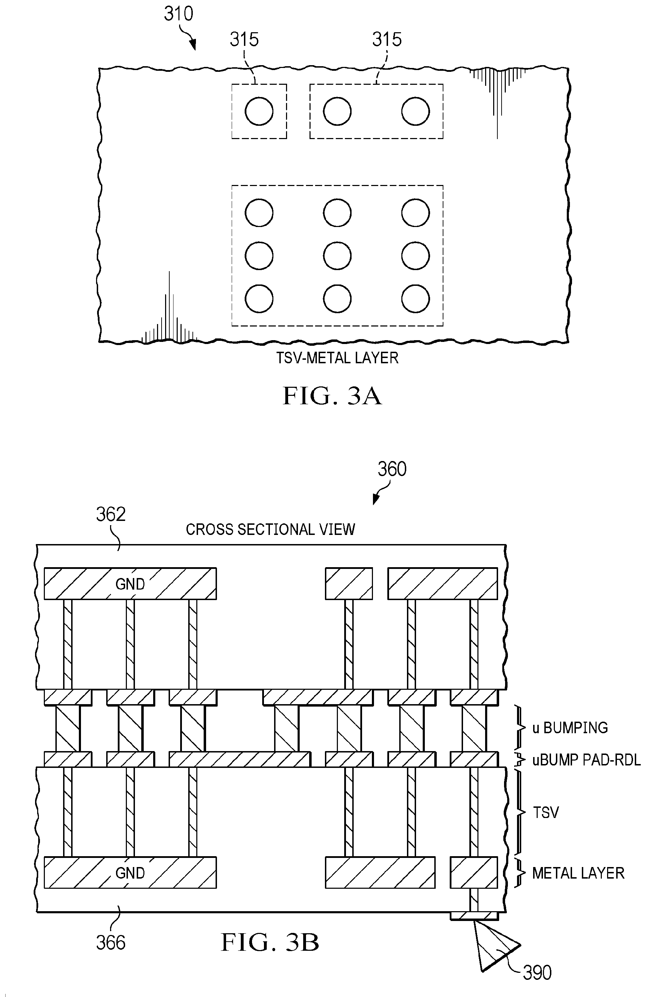

Turning now to **Figures 3A-3B****,** illustrations of test structure are depicted in accordance with an illustrative embodiment. **Figure 3A** apparatus **310** includes through-silicon via metal layer **315.** **Figure 3B** apparatus **360** includes top die **362** and bottom die **366.** Probe point **390** can be electrically contacted at an exterior surface of bottom die **366.**

Still referring to **Figures 3A-3B****,** a minimum of three dummy TSVs are required. A daisy chain can be formed on the microbump pad RDL layer and during the copper pillar bumping process in die stacking post-processes. Probe points can be part of a top metal layer, or a designated bump. This may require additional effort to handle DRC violations. The connectivity checkpoint can be located between a contact point of the ground net and one designated probe point.

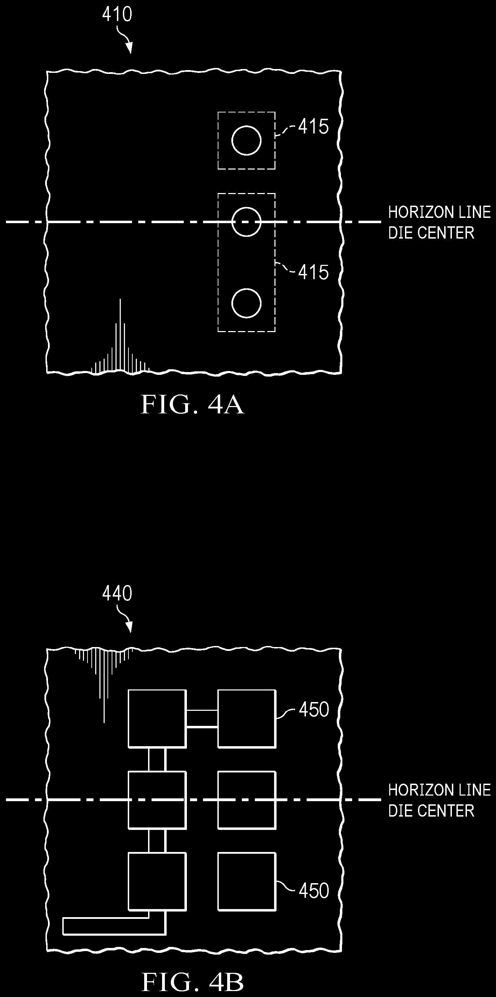

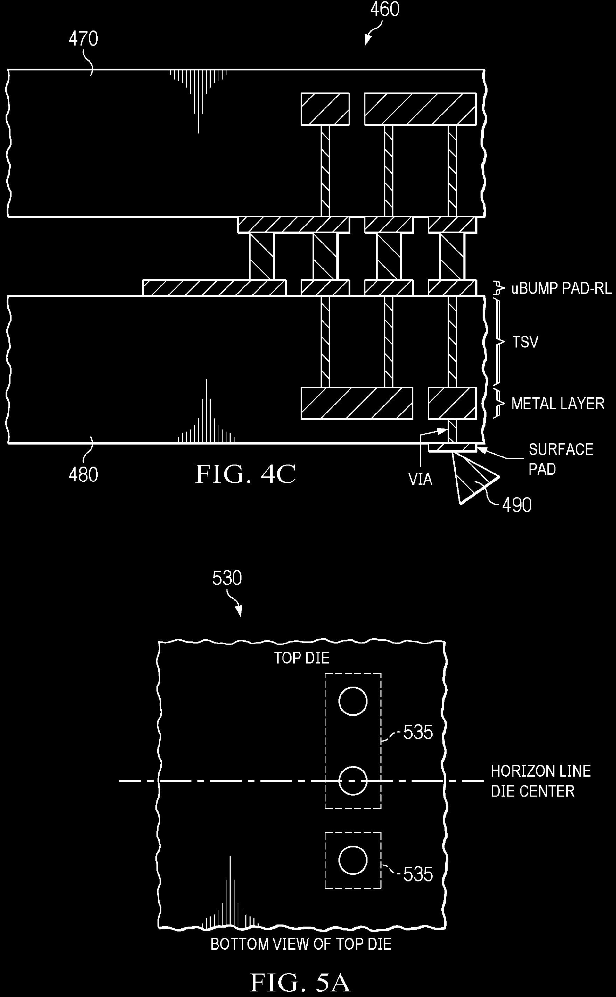

Turning now to **Figures 4A-4C****,** illustrations of test structure are depicted in accordance with an illustrative embodiment. **Figure 4A** apparatus **410** includes through-silicon via metal layer **415.** **Figure 4B** apparatus **440** includes microbump Pad-RDL layer **450.** **Figure 4C** apparatus **460** includes top die **470** and bottom die **480.** Probe point **490** can be contacted at an exterior surface of bottom die **480.**

Still referring to **Figures 4A-4C****,** test structures can be embedded without constraints. Embodiments of this disclosure can have no impact on die size, performance or additional backend processes. Embodiments of this disclosure enable testing of connectivity, including TSVs and interconnection layers between dies. Embodiments of this disclosure can have zero NRE cost.

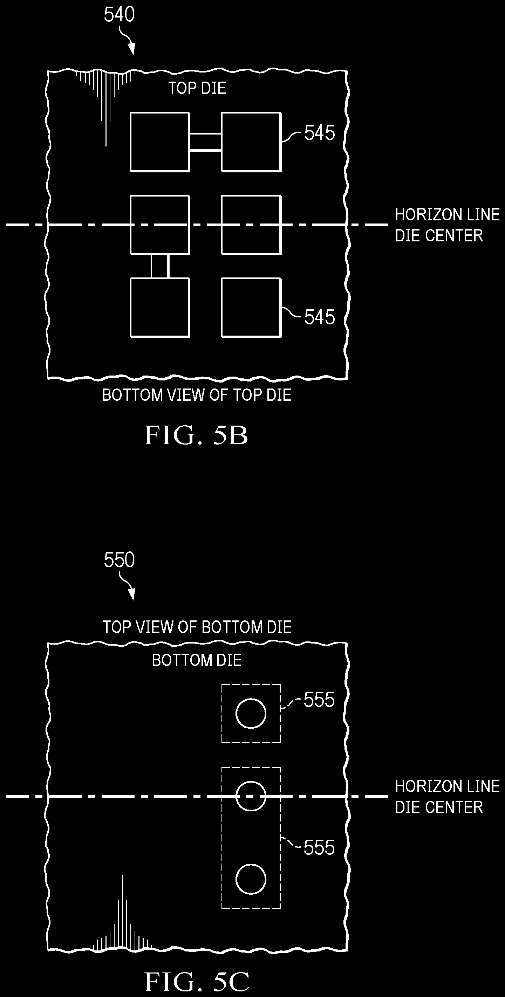

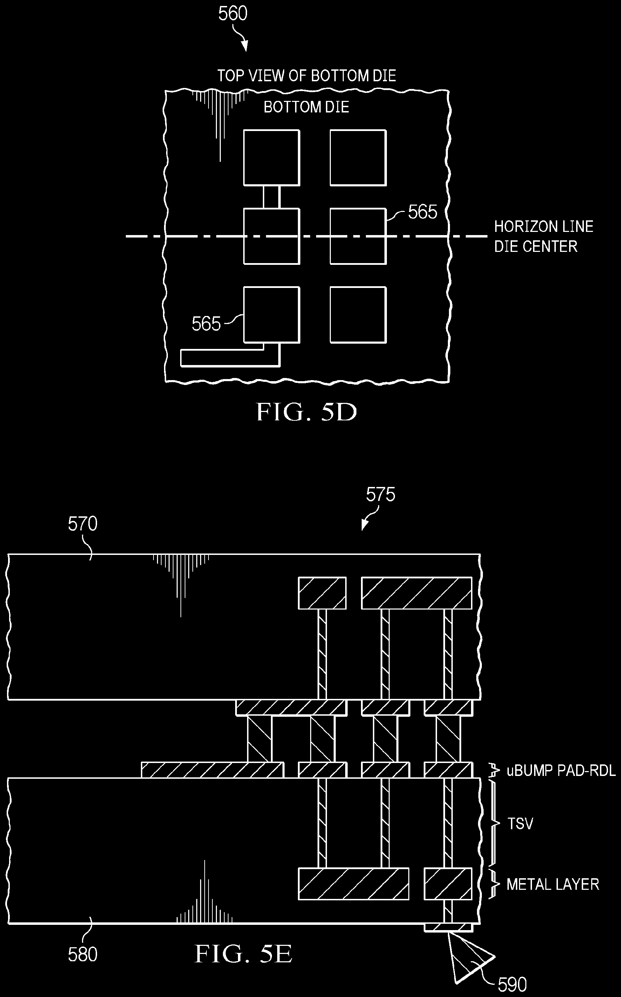

Turning now to **Figures 5A-5E****,** illustrations of test structure are depicted in accordance with an illustrative embodiment. **Figure 5A** apparatus **530** includes through-silicon via metal layer **535.** **Figure 5B** apparatus **540** includes microbump Pad-RDL layer **545.** **Figure 5C** apparatus **550** includes through-silicon via metal layer **555.** **Figure 5D** apparatus **560** includes microbump Pad-RDL layer **565.** **Figure 5E** apparatus **575** includes top die **570** and bottom die **580.** Probe point **590** can be contacted at an exterior surface of bottom die **580.**

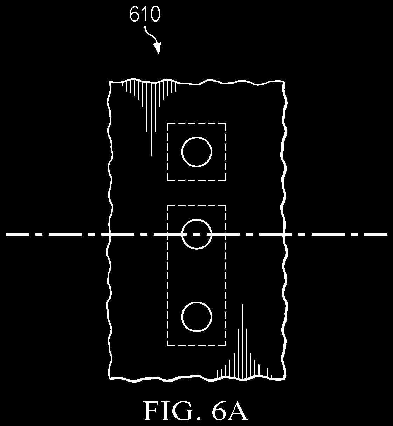

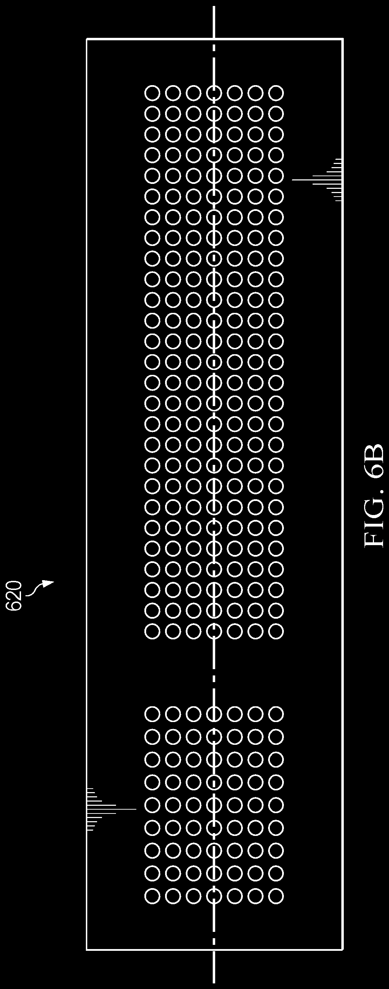

Turning now to **Figures 6A-6B****,** illustrations of test structure are depicted in accordance with an illustrative embodiment. Figure 6A apparatus 610 includes a TSV pattern. Figure 6B apparatus 620 includes a TSV pattern that is repeated and mirrored along a horizontal center line of the die.

Still referring to **Figures 6A-6B****,** for back-to-back connections, the TSV pattern needs to be mirrored from the horizontal centerline of the die. A minimum of three dummy TSVs per die is required, which can be placed where space is available. The embedded structure with TSVs can be coupled with ground, power or test input outputs, as long as there is no impact on electrical performance or other degradation.

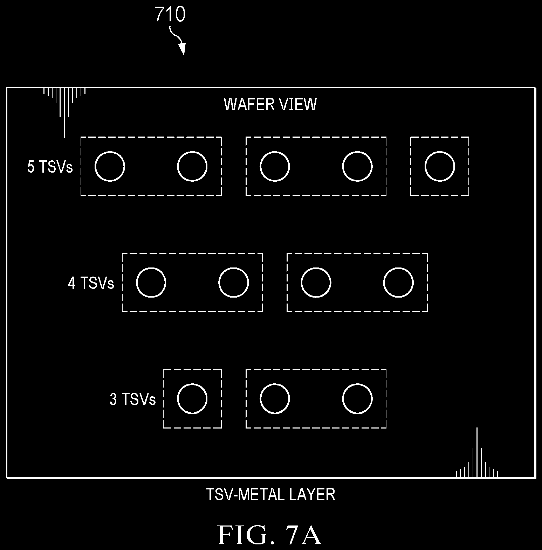

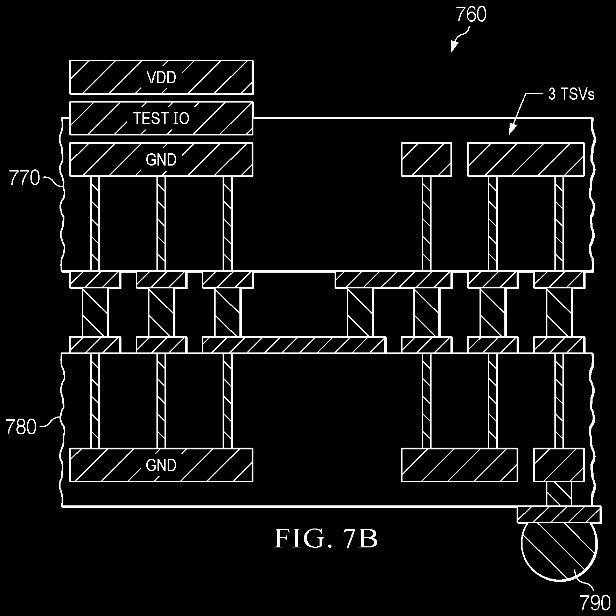

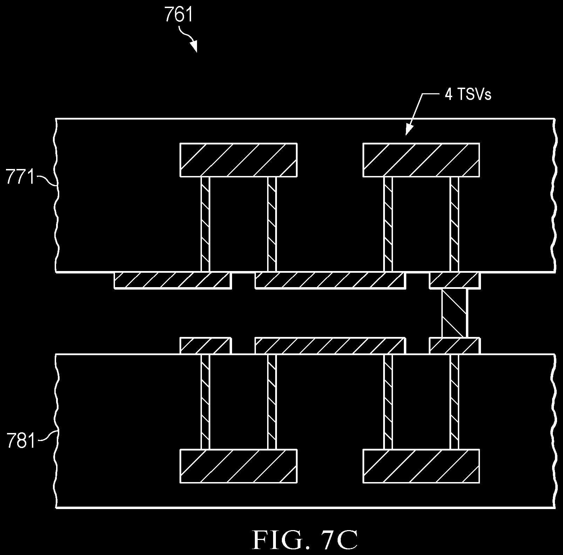

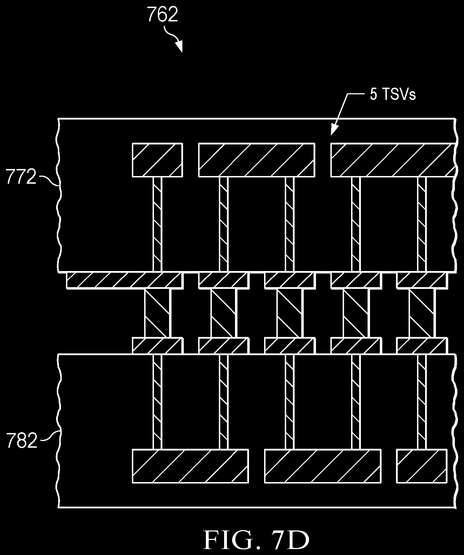

Turning now to **Figures 7A-7D****,** illustrations of test structure are depicted in accordance with an illustrative embodiment. Figure 7A apparatus 710 includes TSV patterns of 3 TSVs, 4 TSVs, and 5 TSVs. **Figure 7B** apparatus **760** includes top die **770** and bottom die **780.** Probe point **790** can be contacted at an exterior surface of bottom die **780.** **Figure 7C** apparatus **761** includes top die **771** and bottom die **781.** Probe point (not shown) can be contacted at an exterior surface of bottom die **781.** **Figure 7D** apparatus **762** includes top die **772** and bottom die **782.** Probe point (not shown) can be contacted at an exterior surface of bottom die **782.**

Still referring to **Figures 7A-7D****,** embodiments of this disclosure can have more than three TSVs on a die as needed and they can be placed wherever space is available. Increasing the number of TSVs provides more points for PCM connection. Embodiments of this disclosure can be connected to any nets such as power, ground or test input outputs as long as there is no impact on performance. C4/C4 bumps can be used instead of probing patents.

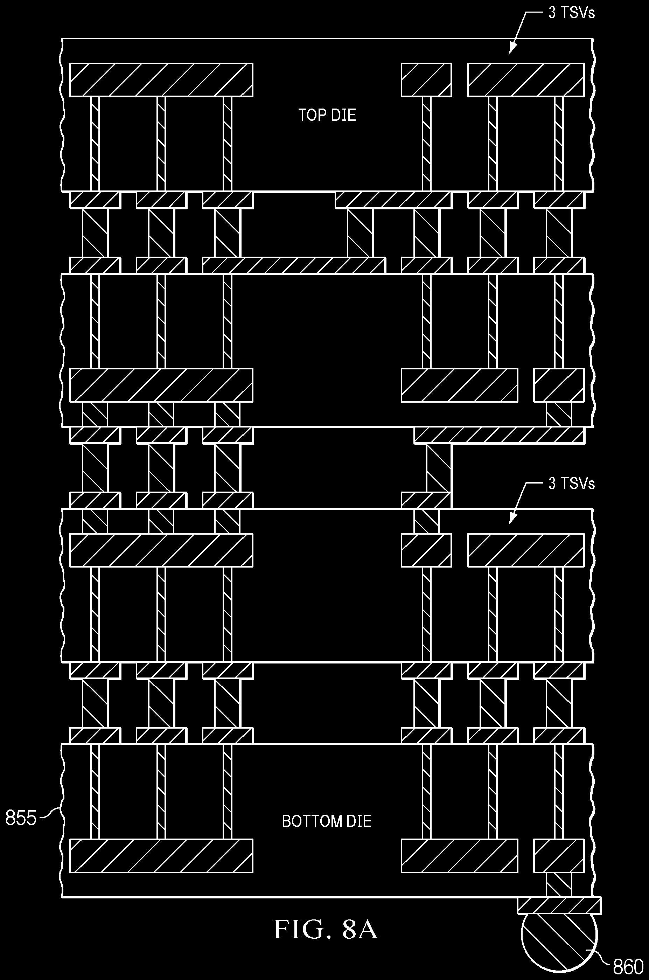

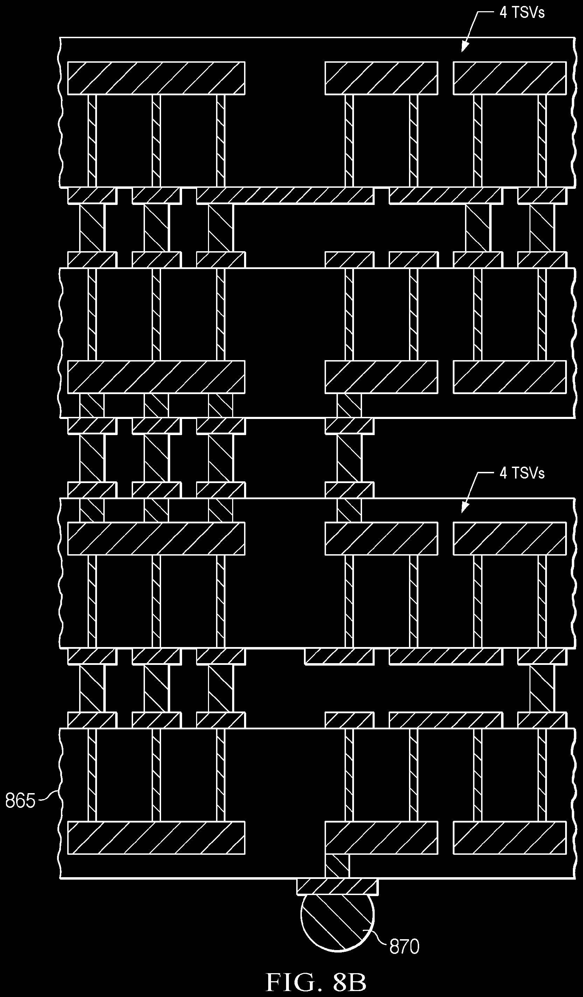

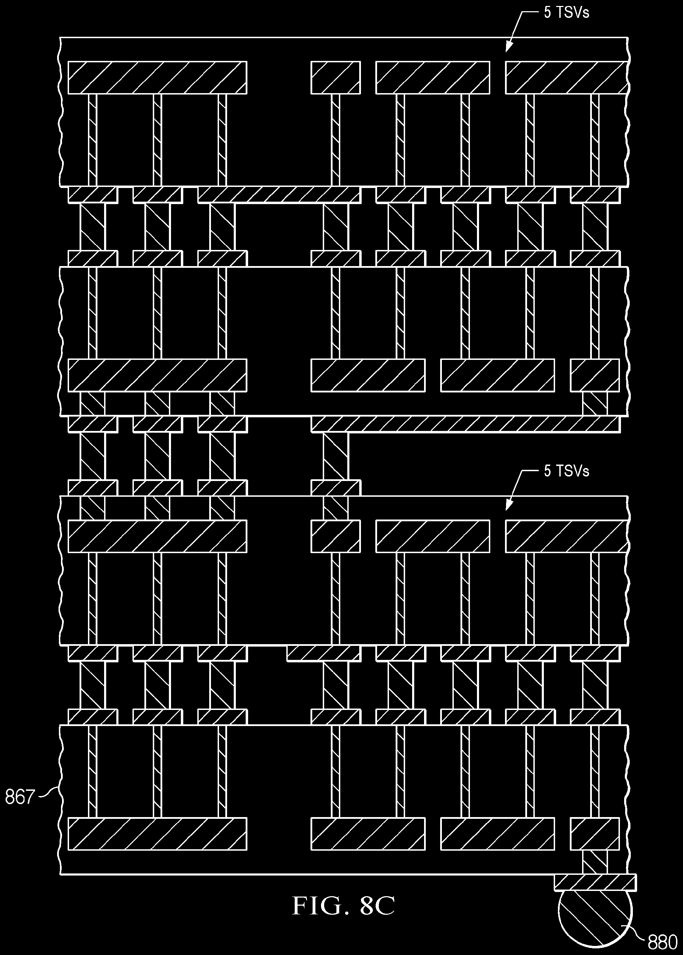

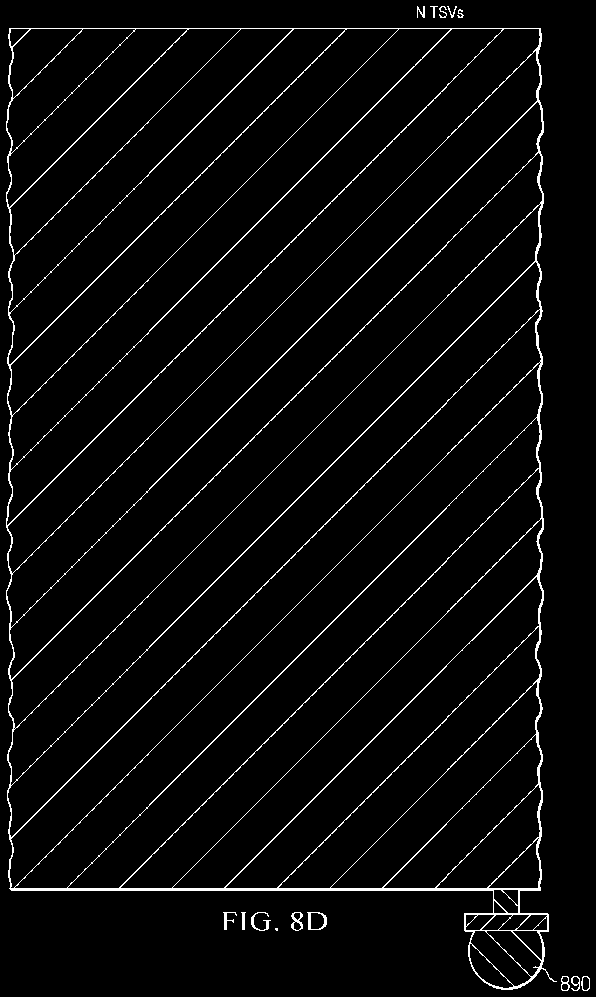

Turning now to **Figures 8A-8D****,** illustrations of test structure are depicted in accordance with an illustrative embodiment. Probe point **860** can be contacted at an exterior surface of bottom die **855.** Probe point **870** can be contacted at an exterior surface of bottom die **865.** Probe point **880** can be contacted at an exterior surface of bottom die **875.** Probe point **890** can be contacted at an exterior surface of a bottom die.

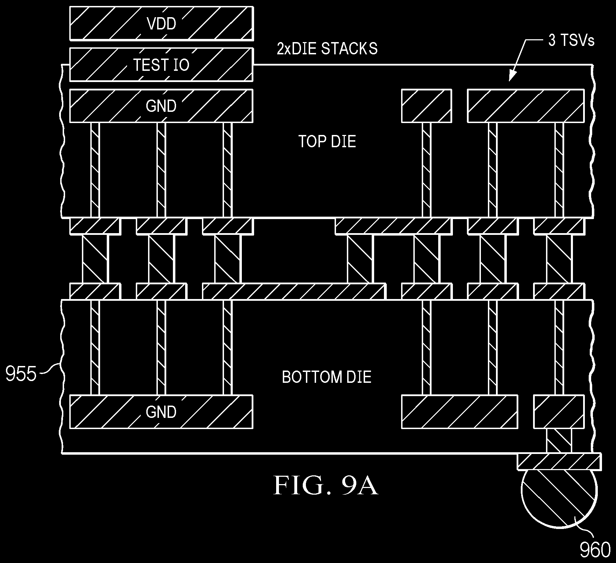

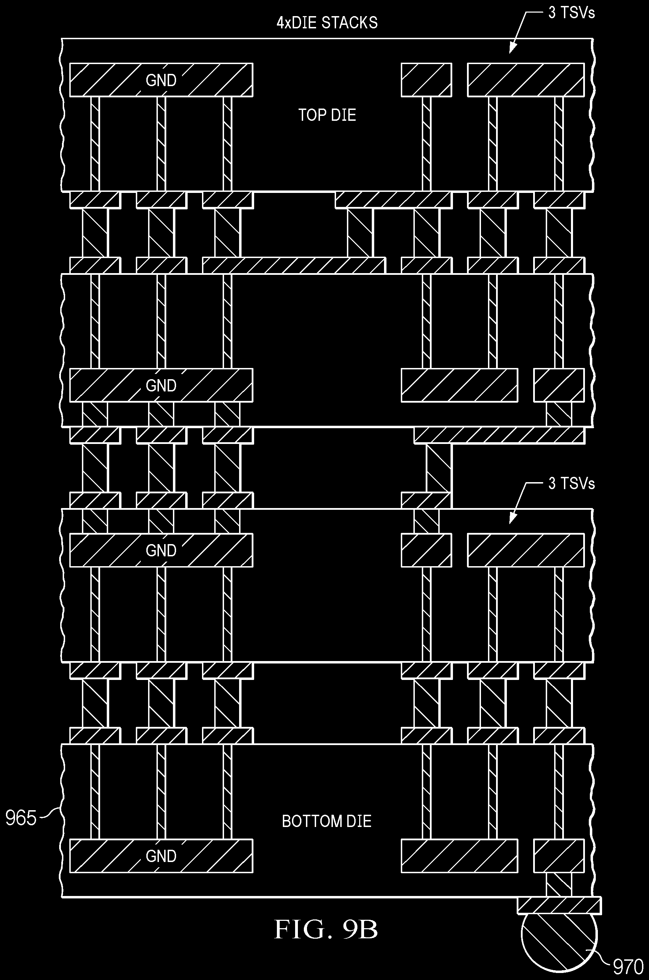

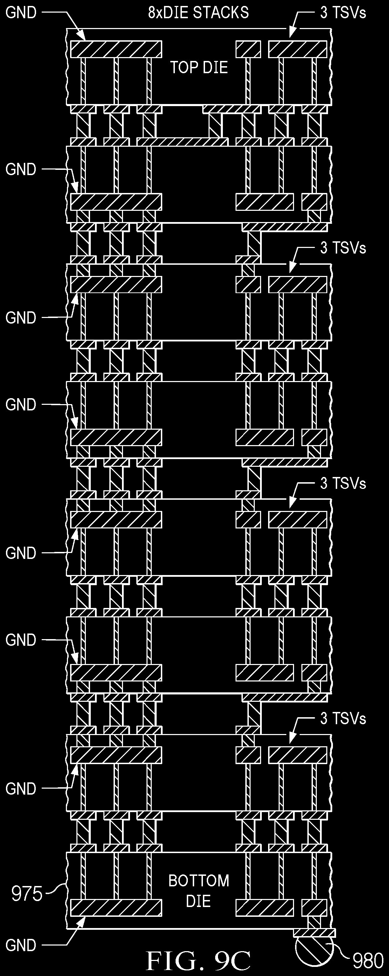

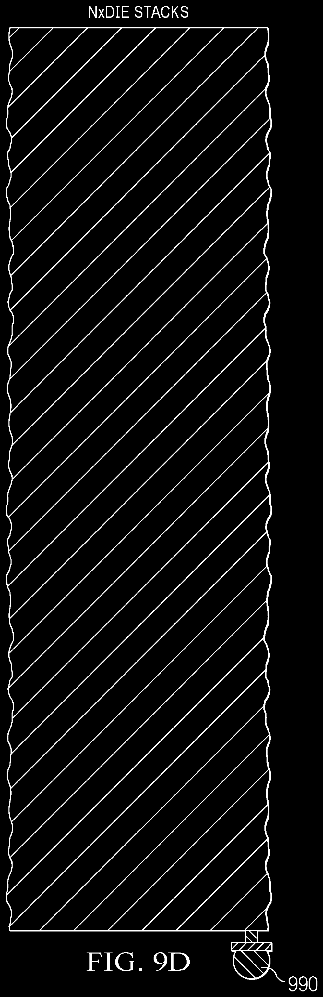

Turning now to **Figures 9A-9D****,** illustrations of test structure are depicted in accordance with an illustrative embodiment. Probe point **960** can be contacted at an exterior surface of bottom die **955.** Probe point **970** can be contacted at an exterior surface of bottom die **965.** Probe point **980** can be contacted at an exterior surface of bottom die **975.** Probe point **990** can be contacted at an exterior surface of a bottom die.

Most failure modes in die stacking occur between TSV stacking and micro-bumping in back-to-back die connections. Embodiments of this disclosure can significantly reduce these failure modes.

Embodiments of this disclosure can provide cost savings. In particular, there are no additional nonrecurring engineering costs required to build mechanical sample dies for process development. Embodiments of this disclosure can provide cost avoidance. In particular, embedded PCM helps suppliers prevent yield loss incidents. Embodiments of this disclosure support miniaturizing features and 3D heterogeneous integration by stacking more dies with TSV back-to-back integration.

The disclosure includes a daisy-chain electrical test structure implemented in two semiconductor dies stacked in a 2.5D configuration, or two or more semiconductor dies stacked in a 3D configuration.

Key features of the test structure include the following. It allows test of vertical die-to-die interconnects and through-silicon vias (TSVs) at the wafer level, prior to integration into a next-level electronic package assembly. It allows test from one side of a die or wafer stack using a standard probing apparatus. Its test structure may be utilized whether the active circuitry is powered or unpowered, and the presence of the test structure does not inhibit the function of the active circuitry when it is powered.

The test structure is a daisy-chain conductive pathway made from a chain of the following. Planar traces on the dies. Vertical conductive pathways including through-silicon vias (TSVs), and chip-to-chip vertical interconnects including but not limited to solder-capped copper columns or micro solder bumps.

One end of the daisy-chain conductive pathway terminates in a surface pad on a die accessible by an electrical probe. The other end of the daisy-chain conductive pathway may connect to a common ground, or may terminate at a surface pad on the same side of the same die.

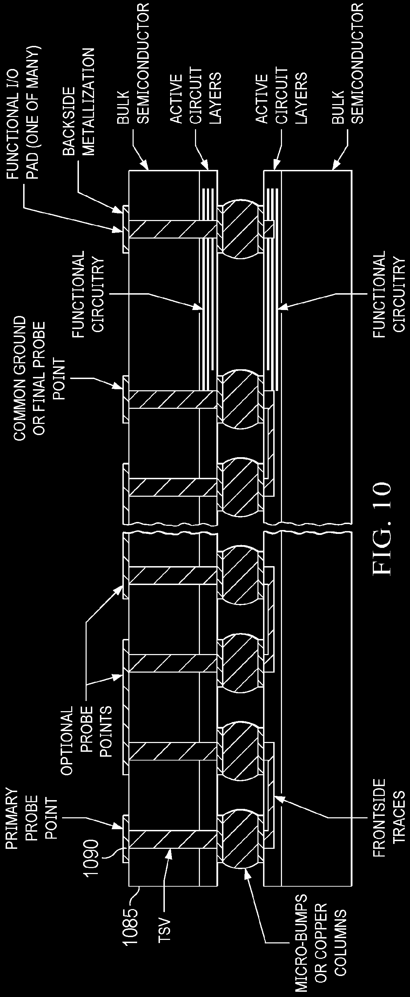

Turning now to **Figure 10****,** an illustration of a test structure is depicted in accordance with an illustrative embodiment. Probe point **1090** can be contacted at an exterior surface of die **1085.**

Still referring to **Figure 10****,** the test structure implemented in two dies can be stacked in a 2.5D or 3D configuration, where the dies are joined front-to-front. Front-to-front means circuit face to circuit face.

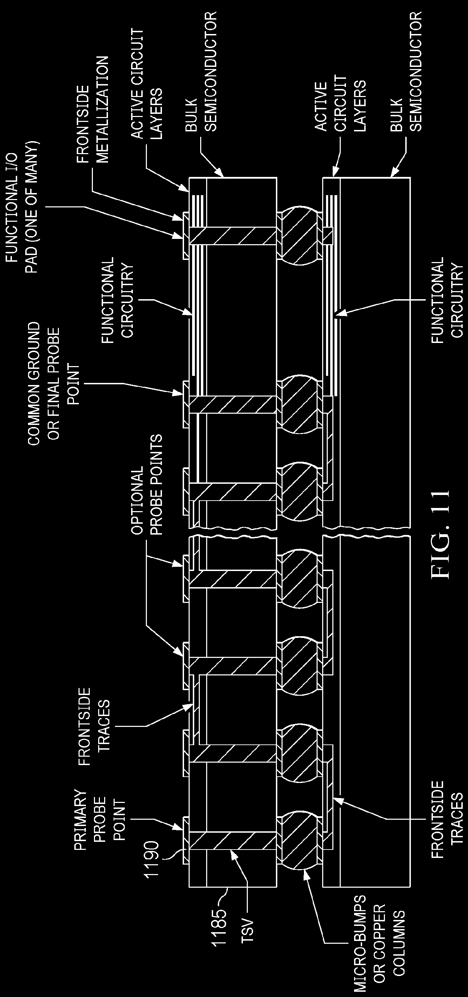

Turning now to **Figure 11****,** an illustration of a test structure is depicted in accordance with an illustrative embodiment. Probe point **1190** can be contacted at an exterior surface of die **1185.**

Still referring to **Figure 11****,** the test structure implemented in two dies can be stacked in a 2.5D or 3D configuration, where the dies are joined front-to-back. Front-to-back means circuit face to reverse face.

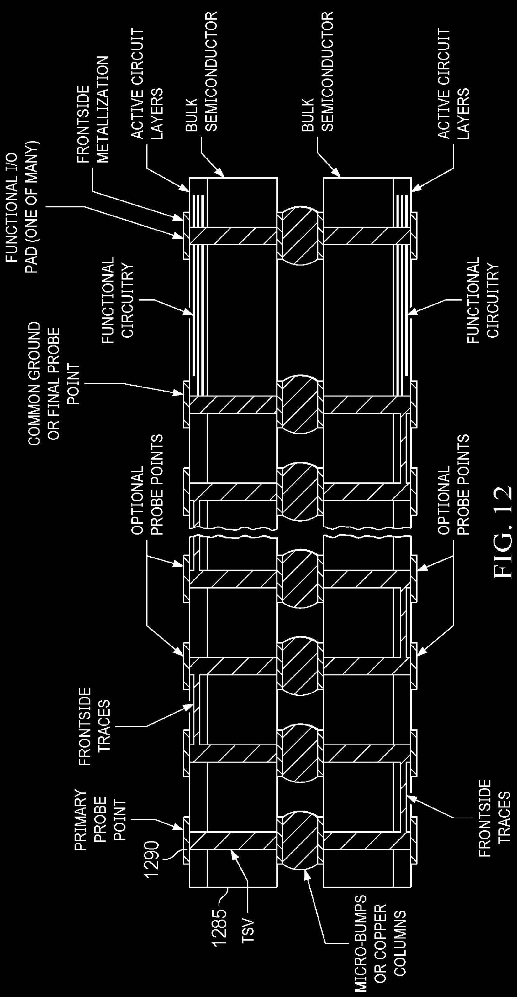

Turning now to **Figure 12****,** an illustration of a test structure is depicted in accordance with an illustrative embodiment. Probe point **1290** can be contacted at an exterior surface of die **1285.**

Still referring to **Figure 12****,** the test structure implemented in two dies can be stacked in a 2.5D or 3D configuration, where the dies are joined back-to-back. Back-to-back means reverse face to reverse face.

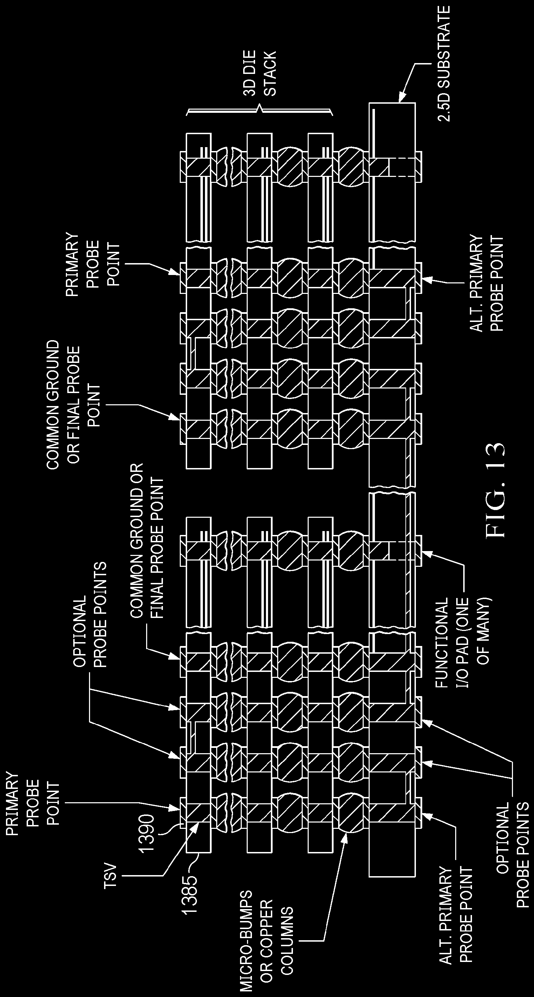

Turning now to **Figure 13****,** an illustration of a test structure is depicted in accordance with an illustrative embodiment. Probe point **1390** can be contacted at an exterior surface of die **1385.**

Still referring to **Figure 13****,** the test structure implemented in multiple dies can be joined in any combination of front the front, front-to-back, or back-to-back in a 3D configuration. Further, these implementations can be mounted on a 2.5D substrate.

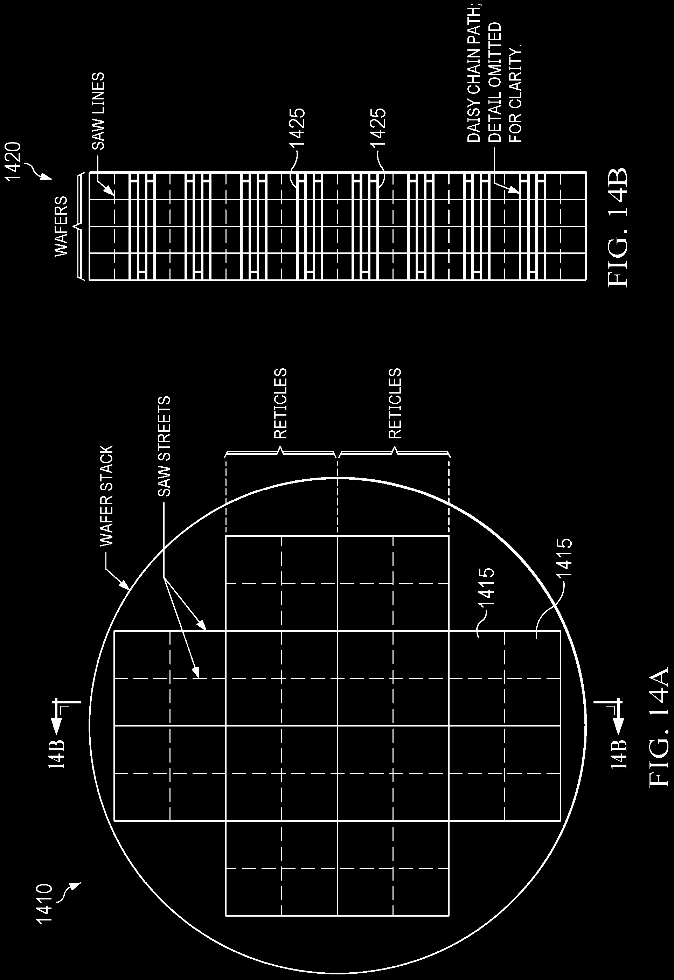

Turning now to **Figures 14A-14B****,** illustrations of a wafer to wafer join test structure are depicted in accordance with an illustrative embodiment. **Figure 14A** apparatus **1410** includes a plurality of die stacks **1415.** **Figure 14B** apparatus **1420** includes a plurality of embedded test structures **1425** that provides through-silicon via connectivity within the plurality of stacked wafer.

Still referring to **Figures 14A-14B****,** the test structure as implemented in two or more wafers can be joined by wafer-wafer bonding. The bonded result is testable as a complete wafer. The wafers may be joined in many different ways, for example, by micro bulbs, copper columns and/or direct the bond.

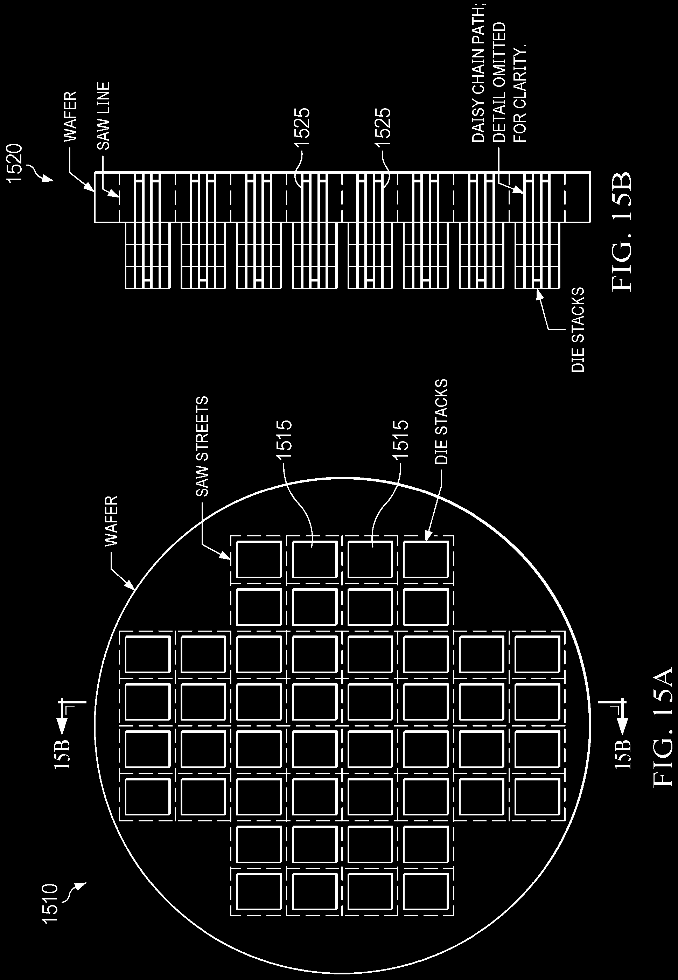

Turning now to **Figures 15A-15B****,** illustrations of a die to wafer join test structure are depicted in accordance with an illustrative embodiment. **Figure 15A** apparatus **1510** includes a plurality of die stacks **1515.** **Figure 15B** apparatus **1520** includes a plurality of embedded test structures **1525** that provides through-silicon via connectivity within the plurality of stacked wafer.

Still referring to **Figures 15A-15B****,** the test structure as implemented in a die to wafer drawing is still testable as a complete wafer. The chips and wafer may be bonded in many different ways, for example, micro solder bumps, copper columns and/or direct bonding.

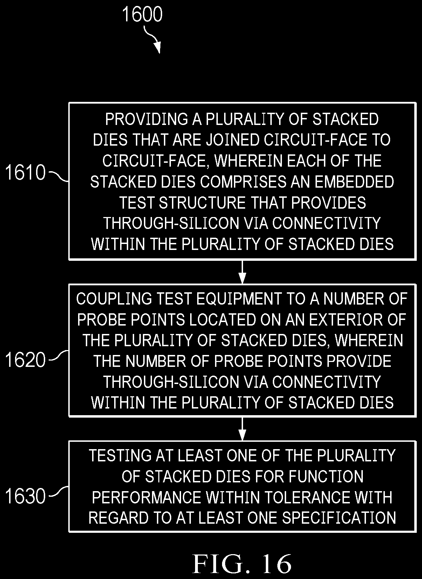

Turning now to **Figure 16****,** a flowchart of a method **1600** of testing a through-silicon via integrated die stack is depicted in accordance with an illustrative embodiment. Block **1610** includes providing a plurality of stacked dies that are joined circuit-face to circuit-face, wherein each of the stacked dies comprises an embedded test structure that provides through-silicon via connectivity within the plurality of stacked dies.

Block **1620** includes coupling test equipment to a number of probe points located on an exterior of the plurality of stacked dies, wherein the number of probe points provide through-silicon via connectivity within the plurality of stacked dies. Block **1630** includes testing at least one of the plurality of stacked dies for function performance within tolerance with regard to at least one specification.

Method **1600** can be used to manufacture a portion (e.g. electronics) of aircraft **100 of** **Figure 1****.** Method **1600** can be performed using the embodiments shown in **Figures 2-15B****.**

In some embodiments, the plurality of stacked dies comprise at least 3 stacked dies. In some embodiments, the number of probe points are located on one exterior side of one of the plurality of stacked dies with regard to a plane defined by a silicon level within one of the plurality of stacked dies. In some embodiments, the number of probe points are located on one exterior face of an exterior die of the plurality of stacked dies. In some embodiments, function performance of a number of chips located within the plurality of stacked dies is unimpeded by the embedded test structure. In some embodiments, a number of chips located within the plurality of stacked dies are unpowered during testing. In some embodiments, the number of probe points comprises a primary probe point, a common ground or final probe point, and at least one optional probe point. In some embodiments, each of the plurality of stacked dies is electrically connected to at least one other of the plurality of stacked dies by micro-bumps or copper columns. In some embodiments, function performance of a number of chips located within the plurality of stacked dies is unimpeded by testing.

In some embodiments, there is a substrate coupled to an active-circuit-layer-face of one of the plurality of stacked dies. In some embodiments, the substrate comprises an embedded test structure that provides through-silicon via connectivity to the plurality of stacked dies. In some embodiments, the substrate comprises a plurality of alternative probe points opposite the plurality of stacked dies.

As used herein, the phrase "at least one of," when used with a list of items, means different combinations of one or more of the listed items may be used and only one of each item in the list may be needed. For example, "at least one of item A, item B, or item C" may include, without limitation, item A, item A and item B, or item B. This example also may include item A, item B, and item C or item B and item C. Of course, any combinations of these items may be present. In other examples, "at least one of" may be, for example, without limitation, two of item A; one of item B; and ten of item C; four of item B and seven of item C; or other suitable combinations. The item may be a particular object, thing, or a category. In other words, at least one of means any combination items and number of items may be used from the list but not all of the items in the list are required.

As used herein, "a number of," when used with reference to items means one or more items. As used herein, "one exterior side of one of the plurality of stacked dies with regard to a plane defined by a silicon level within one of the plurality of stacked dies" means one edge of one die (e.g. chosen from among 4 edges typically presented by a rectilinear or square die); and not one of the 2 faces.

The flowcharts and block diagrams in the different depicted embodiments illustrate the architecture, functionality, and operation of some possible implementations of apparatuses and methods in an illustrative embodiment. In this regard, each block in the flowcharts or block diagrams may represent at least one of a module, a segment, a function, or a portion of an operation or step.

In some alternative implementations of an illustrative embodiment, the function or functions noted in the blocks may occur out of the order noted in the figures. For example, in some cases, two blocks shown in succession may be executed substantially concurrently, or the blocks may sometimes be performed in the reverse order, depending upon the functionality involved. Also, other blocks may be added in addition to the illustrated blocks in a flowchart or block diagram. Some blocks may be optional.

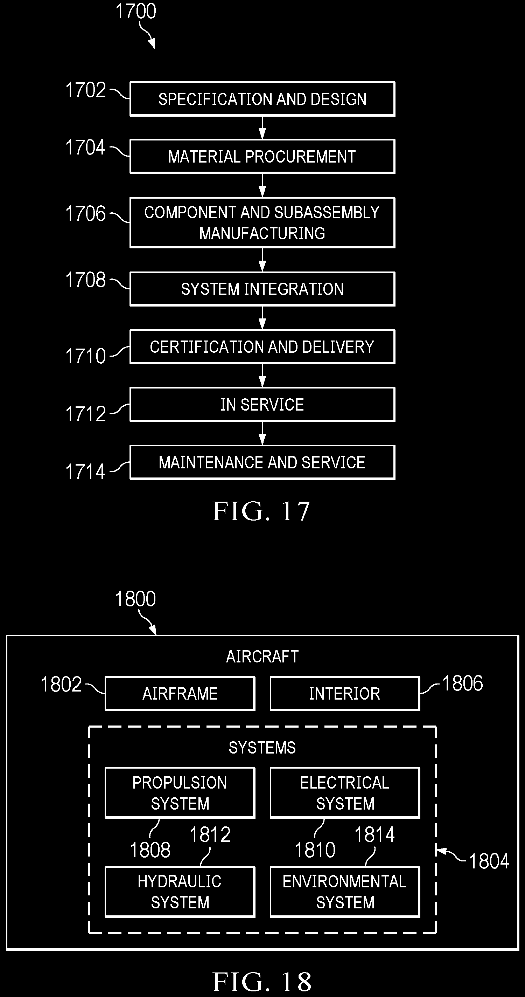

Illustrative embodiments of the present disclosure are described in the context of aircraft manufacturing and service method **1700** as shown in **Figure 17** and aircraft **1800** as shown in **Figure 18****.** Turning first to **Figure 17****,** an illustration of an aircraft manufacturing and service method in a form of a block diagram is depicted in accordance with an illustrative embodiment. During pre-production, aircraft manufacturing and service method **1700** may include specification and design **1702** of aircraft **1800** in **Figure 18** and material procurement **1704.**

During production, component and subassembly manufacturing **1706** and system integration **1708** of aircraft **1800** takes place. Thereafter, aircraft **1800** may go through certification and delivery **1710** in order to be placed in service **1712.** While in service **1712** by a customer, aircraft **1800** is scheduled for routine maintenance and service **1714,** which may include modification, reconfiguration, refurbishment, or other maintenance and service.

Each of the processes of aircraft manufacturing and service method **1700** may be performed or carried out by a system integrator, a third party, and/or an operator. In these examples, the operator may be a customer. For the purposes of this description, a system integrator may include, without limitation, any number of aircraft manufacturers and major-system subcontractors; a third party may include, without limitation, any number of vendors, subcontractors, and suppliers; and an operator may be an airline, a leasing company, a military entity, a service organization, and so on.

With reference now to **Figure 18****,** an illustration of an aircraft in a form of a block diagram is depicted in which an illustrative embodiment may be implemented. In this example, aircraft **1800** is produced by aircraft manufacturing and service method **1700** of **Figure 17** and may include airframe **1802** with plurality of systems **1804** and interior **1806.** Examples of systems **1804** include one or more of propulsion system **1808,** electrical system **1810,** hydraulic system **1812,** and environmental system **1814.** Any number of other systems may be included.

Apparatuses and methods embodied herein may be employed during at least one of the stages of aircraft manufacturing and service method **1700.** One or more illustrative embodiments may be manufactured or used during at least one of component and subassembly manufacturing **1706,** system integration **1708,** in service **1712,** or maintenance and service **1714** of **Figure 17****.**

The description of the different illustrative embodiments has been presented for purposes of illustration and description, and is not intended to be exhaustive or limited to the embodiments in the form disclosed. Many modifications and variations will be apparent to those of ordinary skill in the art. Further, different illustrative embodiments may provide different features as compared to other illustrative embodiments. The embodiment or embodiments selected are chosen and described in order to best explain the principles of the embodiments, the practical application, and to enable others of ordinary skill in the art to understand the disclosure for various embodiments with various modifications as suited to the particular use contemplated.
The present disclosure also includes examples according to the following numbered clauses.
Clause 1. A method of testing a through-silicon via integrated die stack, comprising:
   providing a plurality of stacked dies that are joined circuit-face to circuit-face, circuit-face to reverse-face, or reverse-face to reverse-face; wherein the stacked dies comprise an embedded test structure that provides through-silicon via connectivity within the plurality of stacked dies;
   coupling test equipment to a number of probe points located on an exterior of the plurality of stacked dies, wherein the number of probe points provide through-silicon via connectivity within the plurality of stacked dies; and
   testing at least one of the plurality of stacked dies for function performance within tolerance with regard to at least one specification.
Clause 2. The method of clause 1, wherein the plurality of stacked dies comprise at least 3 stacked dies.
Clause 3. The method of claim 1, wherein the number of probe points are located on one exterior side of one of the plurality of stacked dies with regard to a plane defined by a silicon level within one of the plurality of stacked dies.
Clause 4. The method of clause 1 or clause 2, wherein the number of probe points are located on one exterior face of an exterior die of the plurality of stacked dies.
Clause 5. The method of any preceding clause, wherein function performance of a number of chips located within the plurality of stacked dies is unimpeded by the embedded test structure.
Clause 6. The method of any preceding clause, wherein a number of chips located within the plurality of stacked dies are unpowered during testing.
Clause 7. The method of any preceding clause , wherein the number of probe points comprises a primary probe point, a common ground or final probe point, and at least one optional probe point.
Clause 8. The method of any preceding clause , wherein each of the plurality of stacked dies is electrically connected to at least one other of the plurality of stacked dies by micro-bumps or copper columns.
Clause 9. The method of any preceding clause, wherein function performance of a number of chips located within the plurality of stacked dies is unimpeded by testing.
Clause 10. An apparatus, comprising
   a through-silicon via integrated die stack, comprising:
   a plurality of stacked dies that are joined active-circuit-layer-face to active-circuit-layer-face, active-circuit-layer-face to reverse face, and/or reverse-face to reverse-face; wherein each of the stacked dies comprises an embedded test structure that provides through-silicon via connectivity within the plurality of stacked dies; and
   a number of probe points located on an exterior of the plurality of stacked dies, wherein the number of probe points provide through-silicon via connectivity within the plurality of stacked dies.
Clause 11. The apparatus of clause 10, wherein the plurality of stacked dies comprise at least 3 stacked dies.
Clause 12. The apparatus of clause 10 or clause 11, wherein the number of probe points are located on one exterior side of one of the plurality of stacked dies with regard to a plane defined by a silicon level within one of the plurality of stacked dies.
Clause 13. The apparatus according to any of clauses 10 to 12, wherein the number of probe points are located on one exterior face of an exterior die of the plurality of stacked dies.
Clause 14. The apparatus according to any of clauses 10 to 13, wherein function performance of a number of chips located within the plurality of stacked dies is unimpeded by the embedded test structure.
Clause 15. The apparatus according to any of clauses 10 to 14, wherein the number of probe points comprises a primary probe point, a common ground or final probe point, and at least one optional probe point.
Clause 16. The apparatus according to any of clauses 10 to 15, wherein each of the plurality of stacked dies is electrically connected to at least one other of the plurality of stacked dies by micro-bumps or copper columns.
Clause 17. The apparatus according to any of clauses 10 to 16, further comprising a substrate coupled to an active-circuit-layer-face of one of the plurality of stacked dies.
Clause 18. The apparatus of clause 17, wherein the substrate comprises an embedded test structure that provides through-silicon via connectivity to the plurality of stacked dies.
Clause 19. The apparatus of clause 18, wherein the substrate comprises a plurality of alternative probe points opposite the plurality of stacked dies.
Clause 20. An apparatus, comprising
   a through-silicon via integrated wafer stack, comprising:
   a plurality of stacked wafers that are joined active-circuit-layer-face to active-circuit-layer-face, active-circuit-layer-face to reverse-face, or reverse-face to reverse-face; wherein each of the stacked wafers comprises a plurality of embedded test structures that provides through-silicon via connectivity within the plurality of stacked wafer; and
   a number of probe points located on an exterior face of the plurality of stacked wafers, wherein the number of probe points provide through-silicon via connectivity within the plurality of stacked wafers.

## Claims

1. A method of testing a through-silicon via integrated die stack (214), comprising:
providing a plurality of stacked dies that are joined circuit-face to circuit-face, circuit-face to reverse-face, or reverse-face to reverse-face; wherein the stacked dies comprise an embedded test structure (240) that provides through-silicon via connectivity within the plurality of stacked dies;
coupling test equipment (250) to a number of probe points located on an exterior of the plurality of stacked dies, wherein the number of probe points provide through-silicon via connectivity within the plurality of stacked dies; and
testing at least one of the plurality of stacked dies for function performance within tolerance with regard to at least one specification (275).

2. The method of claim 1, wherein the plurality of stacked dies comprise at least 3 stacked dies.

3. The method of claim 1 or claim 2, wherein the number of probe points are located on one exterior side of one of the plurality of stacked dies with regard to a plane (236) defined by a silicon level (234) within one of the plurality of stacked dies;
and/or wherein the number of probe points are located on one exterior face of an exterior die of the plurality of stacked dies.

4. The method of any preceding claim, wherein function performance of a number of chips located within the plurality of stacked dies is unimpeded by the embedded test structure (240);
and/or wherein function performance of a number of chips located within the plurality of stacked dies is unimpeded by testing.

5. The method of any preceding claim, wherein a number of chips located within the plurality of stacked dies are unpowered during testing.

6. The method of any preceding claim, wherein the number of probe points comprises a primary probe point, a common ground or final probe point, and at least one optional probe point.

7. The method of any preceding claim, wherein each of the plurality of stacked dies is electrically connected to at least one other of the plurality of stacked dies by micro-bumps or copper columns.

8. An apparatus, comprising:
a through-silicon via integrated die stack (214), comprising:
a plurality of stacked dies that are joined active-circuit-layer-face to active-circuit-layer-face, active-circuit-layer-face to reverse face, and/or reverse-face to reverse-face; wherein each of the stacked dies comprises an embedded test structure (240) that provides through-silicon via connectivity within the plurality of stacked dies; and
a number of probe points located on an exterior of the plurality of stacked dies, wherein the number of probe points provide through-silicon via connectivity within the plurality of stacked dies.

9. The apparatus of claim 8, wherein the plurality of stacked dies comprise at least 3 stacked dies.

10. The apparatus of claim 8 or claim 9, wherein the number of probe points are located on one exterior side of one of the plurality of stacked dies with regard to a plane (236) defined by a silicon level (234) within one of the plurality of stacked dies;
and/or wherein the number of probe points are located on one exterior face of an exterior die of the plurality of stacked dies.

11. The apparatus according to any of claims 8 to 10, wherein function performance of a number of chips located within the plurality of stacked dies is unimpeded by the embedded test structure (240).

12. The apparatus according to any of claims 8 to 11, wherein the number of probe points comprises a primary probe point, a common ground or final probe point, and at least one optional probe point;
and/or wherein the substrate comprises a plurality of alternative probe points opposite the plurality of stacked dies.

13. The apparatus according to any of claims 8 to 12, wherein each of the plurality of stacked dies is electrically connected to at least one other of the plurality of stacked dies by micro-bumps or copper columns.

14. The apparatus according to any of claims 8 to 13, further comprising a substrate coupled to an active-circuit-layer-face of one of the plurality of stacked dies;
optionally wherein the substrate comprises an embedded test structure (240) that provides through-silicon via connectivity to the plurality of stacked dies.

15. An apparatus, comprising:
a through-silicon via integrated wafer stack (212), comprising:
a plurality of stacked wafers that are joined active-circuit-layer-face to active-circuit-layer-face, active-circuit-layer-face to reverse-face, and/or reverse-face to reverse-face; wherein each of the stacked wafers comprises a plurality of embedded test structures (1425, 1525) that provides through-silicon via connectivity within the plurality of stacked wafers; and
a number of probe points located on an exterior face of the plurality of stacked wafers, wherein the number of probe points provide through-silicon via connectivity within the plurality of stacked wafers.
